(19) **Europäisches Patentamt / European Patent Office / Office européen des brevets**

(11) **EP 3 384 521 B1**

(12) **FASCICULE DE BREVET EUROPEEN**

(45) Date de publication et mention de la délivrance du brevet:
**13.08.2025 Bulletin 2025/33**

(51) Classification Internationale des Brevets (IPC):
**H01L 21/20** (2006.01) **C30B 29/40** (2006.01)
**H10H 20/01** (2025.01) **H10H 20/817** (2025.01)

(21) Numéro de dépôt: **16805094.6**

(22) Date de dépôt: **30.11.2016**

(52) Classification Coopérative des Brevets (CPC):
**H01L 21/0254; C30B 25/04; C30B 25/186; C30B 29/403; H01L 21/02381; H01L 21/02433; H01L 21/02458; H01L 21/02488; H01L 21/02639; H01L 21/02647; H10H 20/01335; H10H 20/817**

(86) Numéro de dépôt international:
**PCT/EP2016/079345**

(87) Numéro de publication internationale:
**WO 2017/093359 (08.06.2017 Gazette 2017/23)**

(54) **PROCÉDÉ PERMETTANT D'OBTENIR SUR UN SUBSTRAT CRISTALLIN UNE COUCHE SEMI-POLAIRE DE NITRURE**

VERFAHREN ZUR HERSTELLUNG EINER HALBPOLAREN NITRIDSCHICHT AUF EINEM KRISTALLINEN SUBSTRAT

METHOD FOR OBTAINING A SEMI-POLAR NITRIDE LAYER ON A CRYSTALLINE SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.11.2015 FR 1561619**

(43) Date de publication de la demande:
**10.10.2018 Bulletin 2018/41**

(73) Titulaires:
• **Commissariat à l'Energie Atomique et aux Energies Alternatives**
  **75015 Paris (FR)**
• **Centre National de la Recherche Scientifique (CNRS)**
  **75016 Paris (FR)**

(72) Inventeurs:
• **FEUILLET, Guy**
  **38410 Saint-Martin d'Uriage (FR)**
• **EL KHOURY MAROUN, Michel**
  **06600 Antibes (FR)**
• **VENNEGUES, Philippe**
  **06600 Antibes (FR)**
• **ZUNIGA PEREZ, Jesus**
  **06410 Biot (FR)**

(74) Mandataire: **IPAZ**
  **Bâtiment Platon**
  **Parc Les Algorithmes**
  **91190 Saint-Aubin (FR)**

(56) Documents cités:
**WO-A1-2022/225901    US-A1- 2012 119 218**
**US-A1- 2012 276 722**

• **CAO J ET AL: "Improved quality GaN by growth on compliant silicon-on-insulator substrates using metalorganic chemical vapor deposition", JOURNAL OF APPLIED PHYSICS, AMERICAN INSTITUTE OF PHYSICS, US, vol. 83, no. 7, 1 April 1998 (1998-04-01), pages 3829 - 3834, XP012044956, ISSN: 0021-8979, DOI: 10.1063/ 1.366613**

- IMURA ET AL: "Annihilation mechanism of threading dislocations in AIN grown by growth form modification method using V/III ratio", JOURNAL OF CRYSTAL GROWTH, ELSEVIER, AMSTERDAM, NL, vol. 300, no. 1, 28 February 2007 (2007-02-28), pages 136 - 140, XP005915229, ISSN: 0022-0248, DOI: 10.1016/J.JCRYSGRO.2006.11.013
- ZUBIA D ET AL: "Nanoheteroepitaxial growth of GaN on Si by organometallic vapor phase epitaxy", APPLIED PHYSICS LETTERS, A I P PUBLISHING LLC, US, vol. 76, no. 7, 14 February 2000 (2000-02-14), pages 858 - 860, XP012025868, ISSN: 0003-6951, DOI: 10.1063/1.125608
- CHIU CHING-HSUEH ET AL: "Growth of semi-polar GaN-based light-emitting diodes grown on an patterned Si substrate", GALLIUM NITRIDE MATERIALS AND DEVICES VI, SPIE, 1000 20TH ST. BELLINGHAM WA 98225-6705 USA, vol. 7939, no. 1, 10 February 2011 (2011-02-10), pages 1 - 5, XP060010970, DOI: 10.1117/12.876656

# EP 3 384 521 B1

**Description**

DOMAINE TECHNIQUE DE L'INVENTION

La présente invention concerne, d'une manière générale, des diodes électroluminescentes (LED). Elle concerne plus spécifiquement les LED obtenues à partir d'une couche épitaxiale comprenant au moins un nitrure (N) obtenu avec l'un au moins parmi les matériaux suivants : gallium (Ga), indium (In) et aluminium (Al).

ÉTAT DE LA TECHNIQUE

Les diodes électroluminescentes réalisées à partir d'un composé nitruré obtenu avec un ou plusieurs matériaux incluant notamment le gallium (GaN), et capable d'émettre dans le bleu, sont bien connus depuis déjà plus d'une décennie. Cependant, leur aptitude à pouvoir aussi émettre efficacement dans une gamme de longueurs d'ondes plus grandes, typiquement dans la gamme du spectre visible correspondant au vert et au rouge, se heurte à des difficultés intrinsèques liées à la symétrie cristalline des matériaux utilisés qui limite l'efficacité de conversion courant-lumière des diodes conçues pour émettre dans cette gamme de longueurs d'ondes. Pouvoir émettre des longueurs d'ondes plus grandes que le bleu nécessite en effet d'avoir recours, pour former la zone active émettrice de lumière, à des alliages nitrurés de gallium et d'indium (GaInN) comportant de fortes concentrations en indium. Un problème qui se pose est de pouvoir incorporer les proportions croissantes d'indium qui sont alors nécessaires dans les alliages GaInN sans dégrader la qualité structurale des zones émettrices et donc la capacité d'émission de celles-ci.

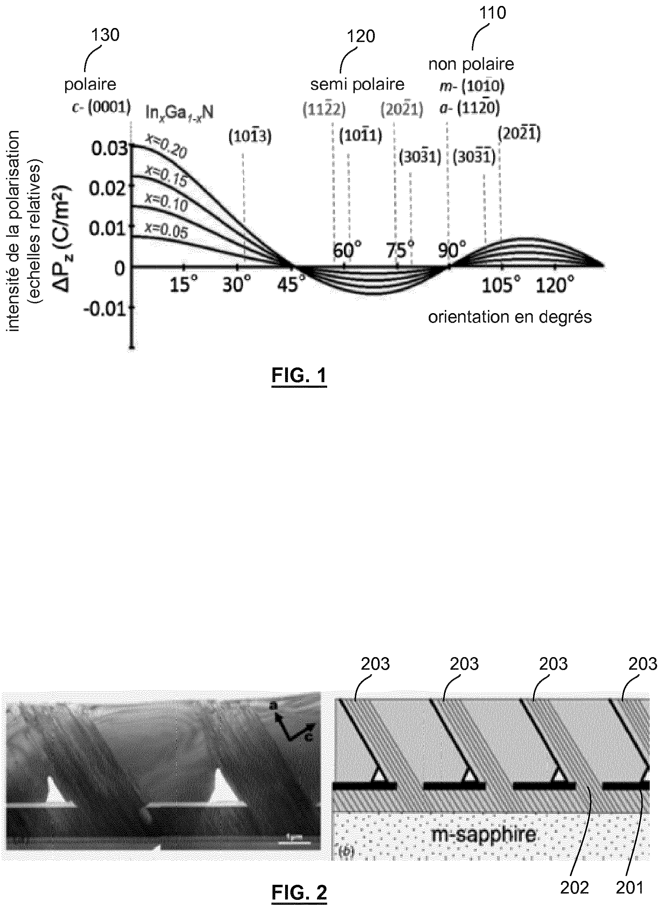

Un deuxième problème qui se pose pour toute la gamme des longueurs d'ondes qui peuvent être produites à partir de ces nitrures, bleu compris, est lié à la symétrie cristalline de cette famille de matériaux. En effet, ces matériaux de symétrie hexagonale, s'ils sont épitaxiés selon une direction cristalline principale dite « c », développent des effets de polarisation spontanée et piézoélectrique le long de cette direction. Un champ électrique interne se crée qui a pour effet négatif de séparer électrons et trous spatialement dans la zone active d'émission ce qui se traduit directement par une perte d'efficacité radiative de la luminescence. La polarisation étant dirigée selon l'axe c, orientation dite « polaire » du cristal, il est avantageux d'utiliser des directions de croissance épitaxiale inclinées par rapport à cet axe, directions pour lesquelles la composante de polarisation sera plus faible voire nulle comme illustré sur la **figure 1.** Cette figure 1 montre aussi l'influence sur ce paramètre de la proportion d'indium **130** contenu dans l'alliage. Ce sont ces directions qui sont communément appelées « non-polaires » **110** ou « semi-polaires » **120.** Par ailleurs, l'incorporation d'indium dans les nitrures employés peut être facilitée lorsque la croissance épitaxiale se fait à partir de surfaces correspondant à certaines de ces orientations. On conçoit donc l'importance qu'il y a de privilégier de telles orientations cristallines afin d'accroître les performances des LEDs vertes et, surtout, celles émettant dans une gamme de longueurs d'ondes plus élevées allant du jaune au rouge, dont l'efficacité demeure à ce jour encore trop faible pour que l'on puisse envisager leur éventuelle utilisation industrielle.

Des méthodes connues pour obtenir des couches épitaxiées de composés nitrurés tels que ceux mentionnés ci-dessus, dans des directions non-polaires et semi-polaires, sont brièvement exposées ci-après.

Le problème qui se pose est de déterminer quel substrat utiliser pour permettre une croissance épitaxiale dans des directions non-polaires **110** ou semi-polaires **120.** Si l'on veut simultanément minimiser la concentration de défauts dans les couches épitaxiées, la méthode la plus appropriée serait d'avoir recours à des substrats de même nature que les couches à épitaxier (homo-substrats). Dans le cas des nitrures mentionnés ci-dessus, les lingots massifs de GaN, tirés dans la direction c, ne sont encore que de faibles dimensions, typiquement d'un diamètre inférieur à un pouce (2,5 cm) ce qui ne permet pas d'y découper des substrats inclinés par rapport à l'axe c de dimensions suffisantes pour les applications industrielles envisagées, ceux-ci étant alors typiquement de dimensions inférieures à quelques cm$^2$.

Une solution qui n'est pas affectée par le problème dimensionnel ci-dessus consiste à utiliser des couches déposées dans la bonne direction cristalline sur un substrat d'orientation adaptée, par exemple un substrat de saphir de plus grande taille et d'orientation adaptée Ces couches, communément qualifiées du terme anglais de « templates », acquièrent l'orientation voulue, c'est-à-dire non-polaire **110** ou semi-polaire **120,** à partir d'une croissance quasi « hétéroépitaxiale » sur le substrat choisi, par exemple en saphir. Cependant on observe que les couches ainsi obtenues sont parcourues par un nombre élevé de fautes d'empilement qui s'étendent dans le plan c, incliné par rapport à la surface, et qui émergent donc à la surface de la couche que l'on a fait croître et, dans une moindre mesure, par un certain nombre de dislocations. La croissance épitaxiale de ces templates ne fait que prolonger ces défauts. Lorsque ces défauts croisent les zones actives, ils y induisent de la recombinaison non radiative ou radiative à plus faibles longueurs d'ondes. Cela explique en partie au moins le moindre rendement de conversion courant-lumière des LEDs fabriquées à partir de telles couches.

Pour tenter de pallier ces difficultés on peut recourir à des méthodes dites de « surcroissance épitaxique latérale » ou ELO, acronyme de l'anglais « epitaxial lateral overgrowth » ayant la même signification. À un certain stade de la croissance de la couche on procède au dépôt d'un masque 201 dans le but, d'une part, de bloquer les dislocations sous le masque et, d'autre part, de courber les dislocations restantes lors de la surcroissance latérale qui se fait au-dessus du masque. Une telle méthode est par exemple décrite dans la publication suivante, parue dans « Semiconductor Science and Technology Volume 27 Number 2 (2012)», intitulée « Defect reduction methods for III-nitride heteroepitaxial films grown along nonpolar and semipolar orientations » par P. Vennéguès et coauteurs. Comme montré sur la **figure 2,** si on constate bien que les fautes et dislocations sous le masque 201 sont effectivement bloquées, les fautes d'empilement ne se courbent pas comme les dislocations et celles 203 qui arrivent à se propager au travers des ouvertures 202 du masque peuvent atteindre la surface. L'illustration de droite de la figure 2 est une vue schématique de l'illustration de gauche qui est une photo.

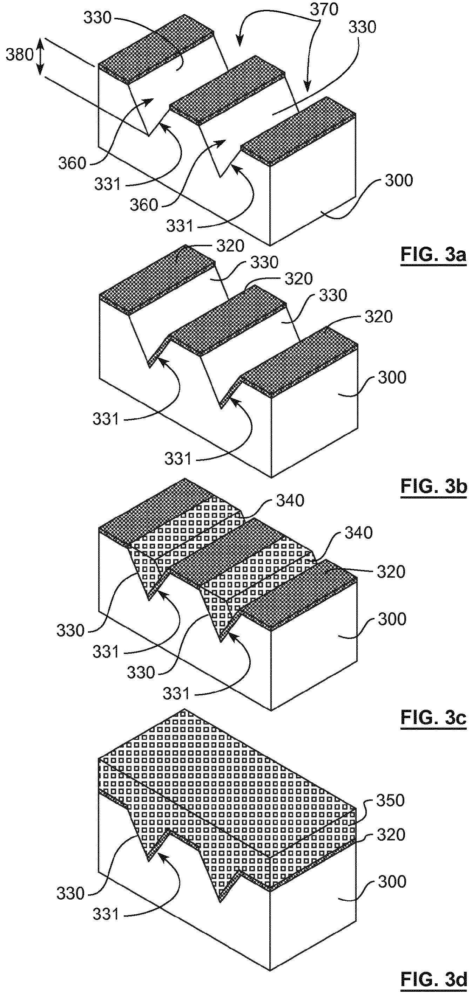

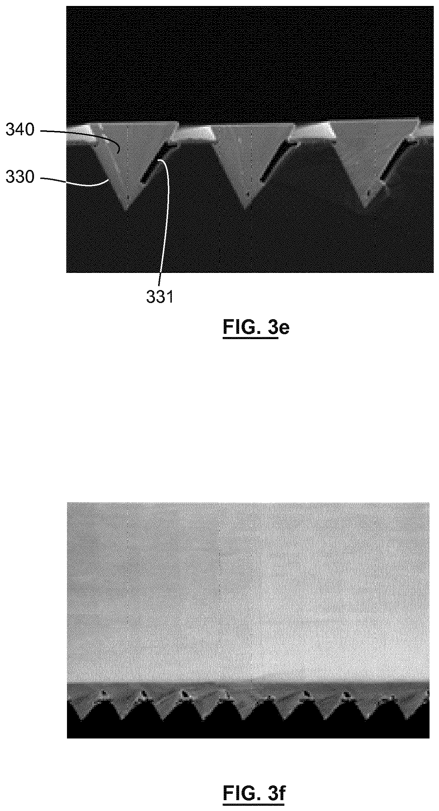

D'autres solutions ont donc été développées qui tentent, plutôt que de bloquer les fautes d'empilement, d'éviter de les créer. Ce type de méthodes repose sur le « facettage » des substrats de façon à reprendre la croissance localement sur des facettes créées à la surface de ces derniers qui permettent l'épitaxie de GaN dans la direction c, i.e. (0001), comme représenté sur la **figure 3** composée des figures 3a à3f. Comme montré sur la figure 3b, hormis les facettes **330,** le substrat est recouvert d'un masque diélectrique **320.** Dans ce cas, les fautes d'empilement, générées en début de croissance, et par nature alignées dans le plan {0001} c sont confinées dans une zone fine proche de l'interface entre la facette et la couche. De plus, la croissance des cristallites sur les facettes s'accompagne de la courbure des dislocations dans les premiers instants de la croissance. L'originalité de l'approche réside dans le fait que l'orientation du substrat **300,** et donc l'inclinaison des facettes, est choisie de façon à ce que la coalescence des différentes cristallites produise finalement, comme montré sur la figure 3d, une surface plane et continue de GaN **350** avec l'orientation semi-polaire voulue. La zone avec fautes d'empilement est de dimension très réduite, typiquement de quelques nanomètres d'épaisseur. De telles méthodes ont été développées par différents laboratoires sur des substrats en silicium ou en saphir. On peut par exemple se référer aux publications suivantes : « T. Honda et Al., Journal of Crystal Growth 242 (1-2), 82 (2002) » ; « B. Leung et Al., Applied Physics Letters 104 (26) (2014) » et « T. Tanikawa et Al., physica status solidi (c) 5 (9), 2966 (2008) ». Pour les substrats en saphir comme pour les substrats en silicium, la révélation des facettes **330** est réalisée chimiquement ou par gravure sèche. Les figures 3a à 3d illustrent la succession des étapes nécessaires pour obtenir la couche continue **350** en partant, par exemple, d'un substrat **300** de silicium {001} avec une désorientation de 7°. Pour la croissance sur silicium, la révélation des facettes **330** d'orientation {111} se fait par attaque chimique à l'aide de KOH ou hydroxyde de potassium. Le substrat de départ est masqué et l'attaque chimique a lieu dans les ouvertures **370** du masque, formant ainsi des rainures 360. Le temps d'attaque fixe la profondeur de gravure **380** et donc la hauteur des facettes {111} 330 exposées. Comme décrit plus haut et puisque la croissance de GaN a une orientation + c sur les facettes {111} 330 du silicium, l'orientation initiale du silicium est choisie précisément de façon à sélectionner l'orientation semi-polaire voulue de la surface de la couche **350** de GaN. Ceci a permis d'obtenir des résultats globalement satisfaisants sur différents types d'orientation du silicium et donc pour différents types d'orientation semi-polaires de la couche de GaN. Un exemple expérimental est illustré par les figures 3e et 3f dans le cas d'une croissance de GaN sur silicium {001} avec une désorientation de 7° dans la direction <110>. On notera ici que l'utilisation de substrats en silicium est toujours préférée dans la mesure où ce matériau est celui qui est le plus largement utilisé par toute l'industrie de la microélectronique et que l'on peut ainsi disposer de substrats de grandes tailles à faibles coûts.

US 2012/119218 A1 présente une méthode de croissance du GaN semi-polaire à partir des facettes des tranchées gravées dans une couche de SOI.

Bien qu'ayant apporté des améliorations certaines les méthodes de croissance semi-polaire hétéro-épitaxiale localisée, brièvement décrites ci-dessus, souffrent encore de nombreuses limitations.

En particulier, la croissance de GaN sur un substrat de silicium se heurte à des difficultés supplémentaires liées à l'apparition d'un phénomène dit de « gravure de refusion » de l'anglais « melt-back etching » lors de l'étape de croissance de la couche de nitrure telle qu'une couche de GaN. Ce phénomène destructif s'explique par la réactivité du silicium avec le Gallium. Notamment, lors de la phase de croissance des cristallites le silicium voit sa température augmenter suffisamment pour qu'il puisse réagir avec le gallium. Cette réaction entraine généralement le creusement de cavités dans le silicium.

Ces cavités détériorent les qualités du substrat et donc les performances des LEDs. Par ailleurs, ils apparaissent de manière aléatoire à la surface du silicium ce qui conduit à une faible homogénéité des LED obtenues à partir d'un même empilement de couches.

Afin d'éviter cette gravure intempestive du silicium par le gallium on peut déposer une couche tampon de nitrure d'aluminium (AIN) sur le silicium avant de commencer la croissance de GaN. Si cette couche tampon de nitrure d'aluminium (AIN) permet de limiter le phénomène de « melt-back etching », en pratique il est rare de pouvoir l'éliminer complétement.

Il existe donc un besoin consistant à proposer une solution pour obtenir une couche de nitrure, par exemple de nitrure de gallium, d'orientation semi-polaire, à partir de facettes orientées selon le plan cristallographique {111} d'une couche de silicium et qui permet de réduire encore l'apparition du phénomène de melt-back etching.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Selon un mode de réalisation la présente invention a pour objet un procédé permettant d'obtenir au moins une couche semi-polaire de nitrure (N) obtenue à partir d'au moins l'un parmi le gallium (Ga), l'indium (In) et l'aluminium (Al) sur une surface supérieure d'une couche cristalline à base de silicium ou de germanium, ledit procédé comprenant les étapes suivantes:

- graver à partir de la surface supérieure de la couche cristalline, une pluralité de rainures parallèles qui s'étendent principalement dans une première direction, chaque rainure comprenant au moins deux facettes inclinées opposées, au moins l'une desdites deux facettes opposées présentant une orientation cristalline {111} ;
- former un masque sur la couche cristalline de telle sorte que les facettes opposées auxdites facettes présentant une orientation cristalline {111} soient masquées et que lesdites facettes présentant une orientation cristalline {111} ne soient pas masquées ;
- croissance épitaxiale de ladite couche semi-polaire de nitrure à partir desdites facettes non masquées.

Avantageusement, ladite gravure est effectuée à partir d'un empilement comprenant la couche cristalline et au moins une couche d'arrêt surmontée par la couche cristalline.

Avantageusement, ladite gravure grave ladite couche cristalline de manière sélective par rapport à ladite couche d'arrêt de manière à ce que ladite gravure s'arrête au contact de ladite couche d'arrêt.

Selon un mode de réalisation ladite étape de croissance épitaxiale comprend :

- une première croissance épitaxiale d'un matériau à base de nitrure d'aluminium (AlN) à partir desdites facettes non masquées qui présentent une orientation cristalline {111} ;
- puis au moins une seconde croissance épitaxiale d'un matériau à base de nitrure de gallium (GaN) à partir dudit matériau à base de nitrure d'aluminium (AlN).

Selon l'invention, la couche cristalline présente une épaisseur inférieure ou égale à 900 nm (10$^{-9}$ mètres).

Dans le cadre du développement de la présente invention il s'est avéré que pour limiter le phénomène de melt-back etching, la couche tampon, par exemple d'AlN, ne peut en pratique, et à un coût non prohibitif, être déposée de façon suffisamment dense et continue pour qu'elle puisse empêcher l'attaque de la couche cristalline à base de silicium ou de germanium par le gallium. Il en résulte une progressive détérioration de la couche de nitrure.

En faisant croître les couches de Aln et de GaN à partir de facettes définies par des rainures dont la profondeur est contrôlée et réduite par gravure avec arrêt sur une couche d'arrêt sous-jacente à la couche cristalline à base de silicium ou de germanium, l'invention permet de réduire voire de supprimer les risques d'apparition de ce phénomène de melt-back etching.

En effet en obtenant les rainures par gravure avec arrêt sur la couche d'arrêt sous-jacente à la couche cristalline à base de silicium ou de germanium, l'invention permet de contrôler de manière particulièrement précise la profondeur des rainures. Cela permet de contrôler de manière très précise la taille des facettes et de réduire leur taille.

Dans le cadre du développement de la présente invention il a été observé que la nucléation du phénomène de melt-back etching a lieu de façon aléatoire sur la surface du substrat.

Par ailleurs il a été constaté, de manière inattendue qu'avec une épaisseur de la couche cristalline inférieure ou égale à 900 nm, on obtient une réduction très forte du risque de nucléation de ce phénomène. En revanche il s'est avéré que pour des épaisseurs plus fortes, typiquement supérieures au micromètre ou à quelques micromètres, la réduction du melt-back etching n'est pas significative. Par ailleurs, pour ces épaisseurs plus importantes, le risque de melt-back etching ne diminue pas ou diminue peu lorsque l'épaisseur de la couche cristalline est réduite.

L'invention permet donc d'amplement minimiser voir d'éliminer ce phénomène.

Le procédé selon la présente invention confère d'autres avantages.

En particulier, les solutions connues basées sur une croissance du nitrure à partir de rainures prévoient que c'est la durée de l'attaque chimique des substrats à base de silicium ou de germanium qui définit la profondeur **331** des rainures, donc la hauteur des facettes **330** d'orientation {111} et parfois leur forme. Pour le silicium, la limite supérieure pour la taille des facettes est déterminée par l'intersection des différents plans {111} qui sont révélés par l'attaque chimique KOH. Pour ce qui est de la limite inférieure, elle dépend quant à elle fortement du contrôle de la phase initiale d'attaque KOH, l'attaque étant souvent initiée localement avant de s'étendre à l'ensemble de la plaque. De plus la vitesse d'attaque dépend étroitement de la concentration en KOH, de la température et de l'orientation du silicium considéré. Dans le cadre du développement de la présente invention on a donc constaté qu'il est en pratique difficile d'assurer une uniformité et une reproductibilité suffisantes, ceci d'autant plus que les tailles de substrats sont grandes. Ainsi, pour des attaques KOH de substrats silicium d'un diamètre de 2 pouces (50mm) on a pu mesurer, dans le cadre du développement de la présente invention, des inhomogénéités de l'ordre de 10 à 50% des profondeurs d'attaque et donc des dispersions de hauteurs de facettes correspondantes sur l'étendue des substrats. La taille des facettes influençant directement la taille des cristallites **340** de GaN issues de chacune des facettes **330,** il a été observé que leur manque d'uniformité en hauteur se traduit alors par des inhomogénéités de taille de cristallite et donc par une coalescence erratique. Ceci est rédhibitoire pour l'obtention d'une couche planaire **350** permettant de réaliser des structures complexes telles que des hétéro-structures à puits quantiques, très exigeantes quant à la perfection cristalline qu'il faut pouvoir obtenir.

L'invention, en permettant de réaliser des facettes dont les tailles sont maîtrisées et bien plus homogènes sur la plaque, permet d'obtenir des couches planes et d'épaisseur plus homogène.

D'autre part, comme on l'a déjà vu ci-dessus, les dislocations issues à l'interface entre une cristallite de GaN et une facette de silicium se courbent vers les faces inférieures et supérieures de celui-ci ce qui permet une réduction rapide de leur densité. Cependant, dans le cadre du développement de la présente invention il a été observé que la largeur de la zone avec dislocations qui émerge à la surface supérieure de la cristallite est directement fonction de la hauteur initiale de la facette de silicium d'où proviennent ces dislocations. Diminuer la largeur des facettes permet donc de diminuer la densité moyenne des dislocations et l'étendue de la zone sur laquelle elles émergent. Ceci demande un contrôle précis de la profondeur d'attaque chimique qu'il est cependant difficile d'obtenir en pratique avec les solutions connues, en raison de la brièveté des temps de gravure que l'on doit mettre en œuvre lors de la création des facettes. Avec les solutions connues les inhomogénéités de taille des facettes aboutissent à l'obtention de cristallites dont la base n'est pas uniforme sur l'étendue du substrat et donc à des densités de dislocations variables d'un bord à l'autre de celui-ci. Pour des applications dans le domaine de l'optique ou de l'électronique, par exemple pour la réalisation de LEDs, de lasers ou encore de transistors en GaN à « haute mobilité électronique » ou HEMTs ceci est rédhibitoire, dans la mesure où les composants seraient de qualité différente selon la position qu'ils occupaient sur le substrat épitaxié.

L'invention, en permettant de réaliser des facettes dont les hauteurs sont plus homogènes sur la plaque, permet d'obtenir des densités de dislocations nulles voire bien plus faibles et en tout cas bien plus homogènes sur une même couche. La qualité des composants obtenus à partir d'un même substrat est donc moins variable.

En option, le procédé de l'invention peut en outre avoir au moins l'une quelconque parmi les caractéristiques et étapes optionnelles suivantes prises séparément ou en combinaison :

Selon un mode de réalisation, l'épaisseur de la couche cristalline est telle que lors de l'étape de gravure les deux facettes inclinées opposées d'une même rainure parviennent à la couche d'arrêt sans se rejoindre.

Selon un mode de réalisation, la première direction, selon lesquelles les rainures s'étendent correspond à une direction commune au plan de la surface supérieure et au plan <111>.

Selon un mode de réalisation, ladite étape de croissance épitaxiale comprend :

- une première croissance épitaxiale d'un matériau à base de nitrure d'aluminium (AlN) à partir desdites facettes non masquées qui présentent une orientation cristalline {111} ;
- puis au moins une seconde croissance épitaxiale d'un matériau à base de nitrure de gallium (GaN) à partir dudit matériau à base de nitrure d'aluminium (AlN).

Selon un mode de réalisation, la première croissance épitaxiale est effectuée de manière à ce que le matériau à base de nitrure de gallium (GaN) recouvre entièrement la couche cristalline.

Selon un mode de réalisation, la première croissance épitaxiale concerne un matériau fait de nitrure d'aluminium (AlN).

Selon un mode de réalisation, les rainures comprennent un fond plat et dans lequel les deux facettes opposées se rejoignent au fond de la rainure.

Selon un mode de réalisation, la couche d'arrêt est configurée pour permettre une croissance épitaxiale à partir de la couche cristalline sans croissance épitaxiale à partir de la couche d'arrêt.

Selon un mode de réalisation la couche d'arrêt est isolante électriquement.

Selon un mode de réalisation la couche d'arrêt est amorphe.

Selon un mode de réalisation la couche d'arrêt ne réagit pas chimiquement avec la couche ladite couche semi-polaire de nitrure.

Selon un mode de réalisation, la couche cristalline est au contact direct de la couche d'arrêt.

Selon un mode de réalisation, l'empilement comprend une couche support surmontée par la couche d'arrêt.

Selon un mode de réalisation, la couche d'arrêt est au contact direct de la couche support.

Selon un mode de réalisation, la couche d'arrêt est obtenue par oxydation d'une surface au moins de la couche support.

Selon un mode de réalisation, la couche d'arrêt est une couche prise parmi : une couche d'oxyde, une couche de SiC, une couche de Al2O3.

Selon un mode de réalisation, la couche cristalline est une couche mince.

Selon un mode de réalisation, la couche cristalline présente une épaisseur comprise entre 2 nm ($10^{-9}$ mètres) et 900 nm et de préférence entre 5nm et 500 nm et de préférence entre 10 nm et 50nm.

Selon un mode de réalisation, la couche cristalline présente une épaisseur inférieure ou égale à 750 nm. Ces épaisseurs permettent de minimiser considérablement le melt back etching.

Selon un mode de réalisation, la couche cristalline présente une épaisseur inférieure ou égale à 600 nm et de préférence inférieure ou égale à 500 nm et de préférence inférieure ou égale à 300 nm et de préférence inférieure ou égale à 200 nm. Ces épaisseurs permettent de minimiser encore plus considérablement le phénomène de nucléation par melt back etching.

Selon un mode de réalisation, la couche cristalline présente une épaisseur comprise entre 50 nm et 600nm et de préférence une épaisseur comprise entre 50 nm et 300nm. Ces épaisseurs permettent de minimiser considérablement le phénomène de nucléation par melt back etching.

Selon un mode de réalisation, la couche cristalline est une couche préalablement obtenue sur un substrat donneur puis reporté sur la couche d'arrêt.

Selon un mode de réalisation, chaque rainure est continue.

Selon un mode de réalisation, l'étape de formation d'un masque comprend un dépôt angulaire d'un matériau de masquage, exécuté de telle sorte que toute la couche cristalline soit recouverte à l'exception desdites facettes qui présentent une orientation cristalline {111}.

Selon un mode de réalisation, le matériau de masquage comprend au moins l'un parmi les matériaux suivants: l'oxyde de silicium (SiO2), le nitrure de silicium (SiN), le nitrure de titane (TiN),

Selon un mode de réalisation, le nitrure est du nitrure de gallium (GaN).

Selon un mode de réalisation, le nitrure est à base de nitrure de gallium (GaN) et dans lequel le nitrure de gallium (GaN) comprend en outre de l'aluminium (Al) et/ou de l'indium (In).

Selon un mode de réalisation, le nitrure est l'un quelconque parmi : le nitrure de gallium (GaN), le nitrure d'indium (InN), le nitrure d'aluminium (AlN), le nitrure d'aluminium gallium (AlGaN), le nitrure d'indium gallium (InGaN), le nitrure d'aluminium gallium indium (AlGaInN), le nitrure d'aluminium indium (AlInN), le nitrure d'aluminium indium Gallium (AlInGaN).

Selon un mode de réalisation, la pluralité de rainures parallèles présente un pas p1 qui est compris entre 50 nm et 20 $\mu$m.

Selon un mode de réalisation, le pas p1 est compris entre 75 nm et 15 $\mu$m.

Selon un mode de réalisation, les rainures parallèles de la pluralité de rainures parallèles s'étendent principalement dans une première direction, et le procédé comprend également les étapes suivantes exécutées après l'étape d'obtention de la pluralité de rainures parallèles et avant l'étape de croissance épitaxiale de la couche cristalline:

- graver une pluralité de tranchées parallèles qui s'étendent dans une seconde direction ayant subi une rotation par rapport à ladite première direction, en interrompant ainsi les rainures continues de manière à former une matrice de facettes individuelles présentant chacune une orientation cristalline {111}.

Avantageusement, pendant ladite étape de croissance épitaxiale, ledit matériau croît uniquement à partir desdites facettes individuelles qui présentent une orientation cristalline {111} et qui forment ladite matrice.

De préférence, les tranchées et les rainures présentant chacune un fond, le fond des tranchées se trouvant à la même profondeur ou en dessous du fond des rainures.

La formation des tranchées, inclinées par rapport aux rainures, permet de réduire les superficies disponibles des facettes présentant une orientation cristalline {111} et à partir desquelles le matériau de nitrure comprenant au moins l'un parmi Ga, In et Al peut croître, en permettant une réduction de l'empreinte et ainsi une réduction des défauts étendus pendant la croissance épitaxiale générée à l'interface GaN/AlN/Si ou AlN/Si tout en imposant la croissance dans la direction +c adéquate.

L'invention et le procédé proposé permettent ainsi de réduire la densité des défauts étendus qui se propagent jusqu'à la surface, et par là-même, sur les orientations semi-polaires qui réduisent fortement les effets de la polarisation, on peut obtenir des LED vertes ayant un meilleur rendement.

Avantageusement pendant ladite étape de croissance épitaxiale, ledit matériau ne croît qu'à partir desdites facettes individuelles qui présentent une orientation cristalline {111} et qui forment ladite matrice.

Selon un mode de réalisation, lesdites première et seconde directions définissent un angle qui est supérieur à 40° et qui est de préférence compris entre 50° et 90°.

Selon un mode de réalisation, ledit angle est compris entre 60° et 90°.

Selon un mode de réalisation, les tranchées sont gravées perpendiculairement aux rainures initiales.

Selon un mode de réalisation, les tranchées ont une profondeur qui est égale ou supérieure à la profondeur des rainures.

Selon un mode de réalisation, les tranchées ont des parois latérales verticales. De préférence les tranchées et les rainures présentent chacune un fond, le fond des tranchées se trouvant à la même profondeur ou en dessous du fond des rainures.

Selon un mode de réalisation, la pluralité de rainures parallèles présente un pas p1 et dans lequel la pluralité de tranchées parallèles présentent un pas p2 qui est supérieur à $\frac{p1*0.8}{2.5}$ et de préférence supérieur à $\frac{p1*0.9}{2.5}$.

Selon un mode de réalisation, la pluralité de rainures parallèles présente un pas p1 et dans lequel la pluralité de tranchées parallèles présente un pas p2 qui est inférieur à 1,1*p1 et de préférence inférieur à p1.

Selon un mode de réalisation, pendant l'étape de la croissance épitaxiale, la température du substrat est maintenue entre 700 et 1300 °C et de préférence entre 900 et 1100 °C.

Selon un mode de réalisation, pendant l'étape de la croissance épitaxiale, la pression est maintenue entre 30 mbar et 1500 mbar et de préférence entre 50 mbar et 700 mbar.

Selon un mode de réalisation, la pluralité de rainures parallèles présentent un pas p1, dans lequel la pluralité de tranchées parallèles présentent un pas p2 qui est compris entre 0,9*p1 et 1,1*p1 et dans lequel le petit angle défini par lesdites première et seconde directions est supérieur à 40° et est de préférence supérieur à 60°.

Selon un mode de réalisation, la couche cristalline est composée de silicium (Si) ou d'un matériau à base de silicium.

Selon un mode de réalisation, ladite étape de gravure d'une pluralité de tranchées parallèle est effectuée après l'étape d'obtention de la pluralité de rainures parallèles et avant l'étape de masquage de la surface supérieure de la couche cristalline, de telle sorte que les facettes opposées auxdites facettes présentant une orientation cristalline {111} soient masquées.

Selon un mode de réalisation, l'invention porte sur un procédé de fabrication d'au moins une diode électroluminescente (LED) configurée de manière à émettre au moins dans la plage du vert des longueurs d'ondes, comprenant le procédé selon l'une quelconque des revendications précédentes permettant d'obtenir une couche semi-polaire d'au moins un matériau comprenant un nitrure (N) et au moins l'un parmi le gallium (Ga), l'Indium (In) et l'aluminium (Al) sur une surface supérieure d'un substrat cristallin.

Selon un autre mode de réalisation, la présente invention a pour objet un dispositif microélectronique comprenant une couche cristalline et une couche semi-polaire d'au moins une couche de nitrure d'au moins l'un parmi le gallium (Ga), l'Indium (In) et l'aluminium (Al) sur une surface supérieure dudit substrat cristallin ,

- la couche cristalline comprenant une pluralité de rainures parallèles, chaque rainure comprenant au moins deux facettes inclinées opposées formant chacune une bande continue, au moins l'une desdites deux facettes opposées présentant une orientation cristalline {111} ;
- ladite couche de nitrure est en contact direct avec les facettes présentant une orientation cristalline {111}.

La couche cristalline surmonte une couche d'arrêt. Chaque rainure s'étend depuis une face supérieure de la couche d'arrêt et traverse toute la couche cristalline.

La couche cristalline présente une épaisseur inférieure ou égale à 900 nm. Selon un mode de réalisation, les rainures présentent un fond plat formé par la face supérieure de la couche d'arrêt.

Selon un mode de réalisation, le dispositif comprenant également une couche de masquage disposée entre la couche cristalline et le nitrure, la couche de masquage couvrant l'intégralité de la surface supérieure de la couche cristalline à l'exception des facettes présentant une orientation cristalline {111}.

Selon un mode de réalisation, l'invention porte sur une diodes électroluminescentes (LED) comprenant un dispositif microélectronique selon l'une quelconque des deux revendications précédentes.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1 est un diagramme montrant l'intensité des phénomènes de polarisation en fonction de l'orientation cristalline.

La FIGURE 2 montre des résultats de croissance d'une couche de nitrure obtenue par surcroissance épitaxique latérale (ELO).

La FIGURE 3, composée des figures 3a à 3f illustre les étapes d'un procédé de croissance semi-polaire hétéro-épitaxiale localisée d'une couche de GaN.

La FIGURE 4, composée des figures 4a à 4i, illustre les étapes d'un exemple de procédé selon l'invention pour obtenir une croissance semi-polaire hétéro-épitaxiale localisée d'une couche de GaN.

Les figures sont données à titre d'exemples et ne sont pas limitatives de l'invention. Elles sont des représentations schématiques de principe destinées à faciliter la compréhension de l'invention et ne sont donc pas nécessairement à la même échelle que les applications pratiques. En particulier, les épaisseurs relatives des différentes couches et films ne sont pas représentatifs de la réalité.

## DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans la description qui suit, l'épaisseur ou la hauteur est prise selon une direction perpendiculaire aux faces principales des différentes couches. Sur les figures, l'épaisseur ou la hauteur est prise selon la verticale.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures

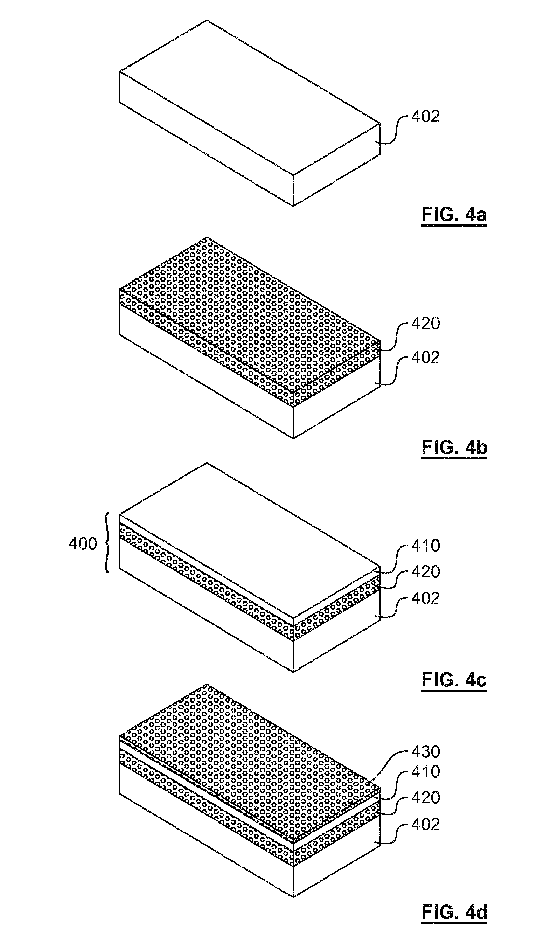

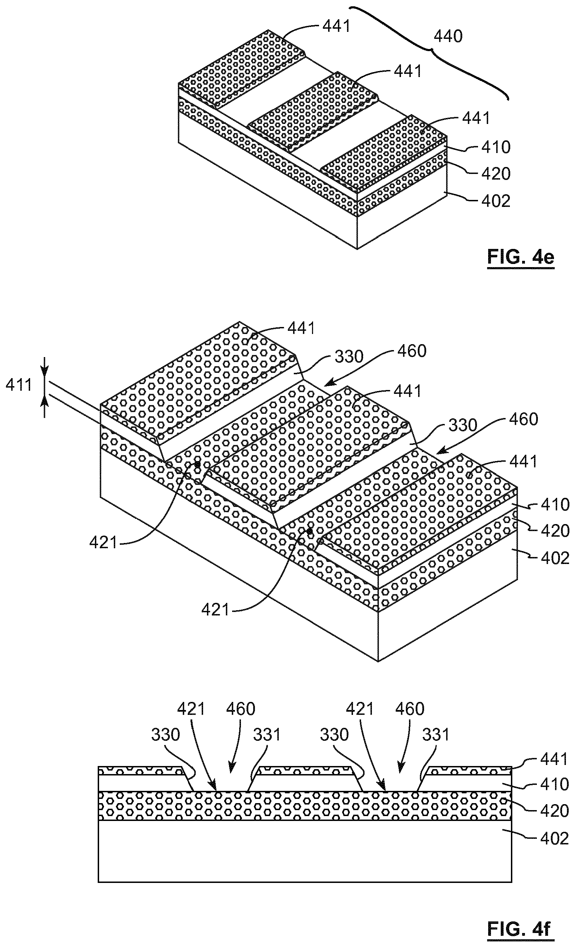

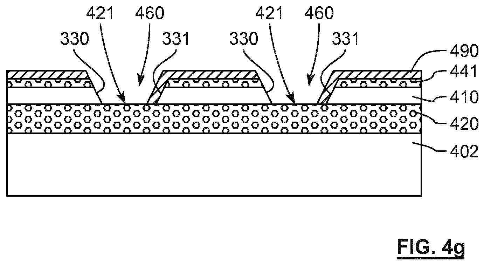

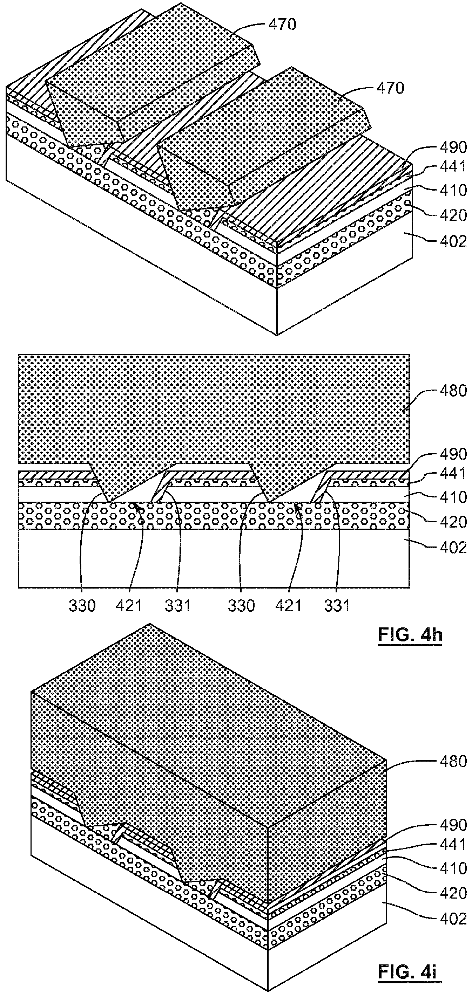

Le principe général du procédé selon l'invention va maintenant être décrit, puis des modes de réalisation non limitatifs seront détaillés en référence aux figures 4aà 4h.

Ce procédé propose une solution pour répondre aux problèmes posés par la croissance d'une couche épitaxiale d'orientation semi-polaire ou non-polaire de nitrure de gallium (GaN) et d'alliages nitrurés incluant l'indium (In) et l'aluminium (Al).

Le procédé de l'invention prévoit avantageusement l'utilisation de substrats silicium élaborés de type SOI, acronyme de l'anglais « silicon on insulator » c'est-à-dire « silicium sur isolant ». Il existe de nombreuses techniques bien connues de production de tels substrats comprenant une fine couche superficielle de silicium de préférence cristallin et qui repose sur une couche continue isolante, qui fera office de couche d'arrêt 420. Cette dernière est souvent de l'oxyde de silicium (SiO2).

La couche cristalline peut ainsi être à base de silicium, c'est-à-dire qu'elle peut être constituée intégralement de silicium ou bien qu'elle peut comprendre du silicium et au moins une autre espèce. Selon un autre mode de réalisation, la couche cristalline est à base de germanium. Dans la suite de la description, l'invention sera décrite en référence à une couche cristalline à base de silicium. Les modes de réalisation décrits ci-dessous sont applicables à une couche cristalline est à base de germanium.

Généralement, la couche isolante repose sur un support, désignée par la suite couche support, épais et destiné à conférer à l'ensemble une rigidité mécanique suffisante. Le support épais ou massif, encore désigné par les termes anglais de « bulk » ou « base wafer » est également souvent fait de silicium.

Plus généralement, l'invention fait usage de substrats de type SOX, sigle utilisé pour désigner tout type de substrat SOI où la couche isolante et le support épais peuvent être faits de matériaux différents du silicium (Si) et de son oxyde (SiO2). Ainsi, la couche support peut être faite d'alumine (Al2O3) ou de carbure de silicium (SiC) ou encore de tout autre matériau couramment utilisé par l'industrie de la microélectronique.

La couche superficielle cristalline, par exemple faite de silicium, peut être obtenue suivant divers procédé connus comme par exemple la méthode bien connue dite « smart-cut ». Dans cette méthode, la couche superficielle est obtenue à partir d'un substrat dit donneur. La couche superficielle est ensuite reportée sur la couche support par collage moléculaire d'une couche isolante généralement faite de SiO2 que l'on a, préalablement au report, créée à la surface de la couche support.

L'orientation cristalline de la couche cristalline doit être telle qu'elle va permettre d'obtenir l'orientation semi-polaire désirée lors de la croissance ultérieure de la couche de nitrure (par exemple GaN) comme cela a été décrit précédemment. Le tableau suivant résume les différentes orientations cristallines de la couche superficielle de silicium qui sont susceptibles de convenir :

| Orientation de la couche supérieure de Si : | autour de : | vers : | Orientation semi-polaire du GaN : |
| --- | --- | --- | --- |
| (001) décalage 7° | [1-10] | [110] | [10-11] |
| (114) décalage 1° | [110] | [-110] | [20-21] |
| (111) décalage 4° | [0-1-1] | [-211] | [20-21] |

(suite)

| Orientation de la couche supérieure de Si : | autour de : | vers : | Orientation semi-polaire du GaN : |
|---|---|---|---|
| (113) | | | [11-22] ou [30-31] |

L'orientation cristalline et la nature de la couche support ou « base wafer » fait de silicium et des autres matériaux mentionnés ci-dessus n'interviennent pas directement dans celles de la couche de nitrure puisque la couche isolante faisant office de couche d'arrêt 420 forme une interface entre la couche support et la couche cristalline superficielle. Pour l'obtention de la couche de nitrure (GaN par exemple), seule la couche cristalline superficielle est à considérer.

Le choix du matériau constituant la couche support pourra être dicté par des considérations autres telles que sa conductibilité thermique, son coefficient de dilatation thermique, sa transparence ainsi que par d'autres paramètres physiques qui peuvent dépendre de l'application particulière qui est faite de l'invention. Si la couche support est faite de silicium son orientation cristalline est communément {100} ou {111}.

L'épaisseur de la couche d'oxyde ou, plus généralement, celle de la couche isolante créée avant report de la couche cristalline superficielle n'est pas non plus un facteur qui aura une influence directe sur le résultat de la mise en œuvre du procédé selon l'invention. Elle est communément comprise dans une gamme de valeurs allant de 150 nm (nanomètre = $10^{-9}$ m) à 900 nm ($\mu$m = $10^{-6}$ m) et plus généralement entre 2 nm ($10^{-9}$ mètres) et 900 nm et de préférence entre 5nm et 500 nm et de préférence entre 10 nm et 50nm.

Selon un mode de réalisation, la couche cristalline présente une épaisseur inférieure ou égale à 750 nm, de préférence inférieure ou égale à 600 nm, de préférence inférieure ou égale à 500 nm et de préférence inférieure ou égale à 300 nm. Ces épaisseurs permettent de minimiser encore plus considérablement le phénomène de nucléation par melt back etching.

Cette couche isolante est choisie de manière à constituer une couche d'arrêt 420 lors de la gravure de révélation des facettes gravées dans la couche cristalline superficielle. Typiquement, la gravure est effectuée par une attaque chimique qui grave la couche cristalline superficielle avec une grande sélectivité par rapport à la couche d'arrêt 420.

La couche d'arrêt 420 n'est pas nécessairement isolante bien que l'utilisation des procédés connus de formation de structures de types SOI soit avantageuse et que ces procédés mettent habituellement en œuvre une couche isolante. Avantageusement, la couche d'arrêt est amorphe. Elle ne réagit chimiquement pas avec ladite couche semi-polaire de nitrure.

La couche d'arrêt 420 permet avantageusement la croissance localisée sur les facettes {111} définies par la couche cristalline superficielle. Plus précisément, la croissance de GaN sur le matériau choisi ne doit pas être possible afin d'obtenir une croissance sélective sur les seules facettes orientées {111} révélées par l'attaque chimique. L'oxyde de silicium (SiO2) présente pour avantage d'être simple d'utilisation, de présenter une bonne sélectivité par rapport au silicium pour de nombreuses chimies de gravures. Par ailleurs, il convient bien pour réaliser le collage moléculaire lors du report de la couche cristalline superficielle. Le nitrure de silicium (SiN) est également un matériau avantageux pour former la couche d'arrêt 420. De préférence la couche d'arrêt 420 est amorphe, en SiO2 ou SiN amorphe par exemple.

La couche d'arrêt 420 peut être de nature différente du SiO2 pour peu que le matériau isolant choisi soit inerte vis-à-vis de l'attaque chimique de révélation des facettes (pratiquée comme on l'a vu à l'aide, par exemple, de KOH) dans la couche superficielle de silicium.

La **figure 4,** composée des figures 4a à 4i, illustre un exemple de mise en œuvre du procédé de l'invention à partir d'un empilement, qui dans ce cas est un substrat SOI **400** illustré par la figure 4c.

L'orientation de la couche cristalline superficielle **410** du substrat, typiquement en silicium, présente un décalage d'orientation du plan cristallin (001) de 7° vers [110] de façon à obtenir ensuite une couche épitaxiale de GaN d'orientation (10-11)

Ce substrat SOI 400 comprend la couche support 402, surmontée par la couche d'arrêt 420, elle-même surmontée par la couche cristalline superficielle 410.

Ce substrat SOI 400 est obtenu par exemple de façon conventionnelle, comme déjà brièvement expliqué ci-dessus et illustré par les figures 4a et 4b, à partir d'une couche support **402** épaisse par exemple faite de silicium qui est oxydée en surface **404** avant report de la couche cristalline superficielle **410** par exemple par la technique dite « smart cut ».

De préférence, avant collage la couche cristalline superficielle **410** est elle-même préalablement oxydée pour faciliter le collage moléculaire. Les couches oxydées en contact forment ainsi la couche d'arrêt **420** intermédiaire du substrat SOI.

Comme illustré sur les figures 4e à 4f on grave ensuite des rainures 460 dans la couche cristalline superficielle 410. Ces rainures sont des motifs en creux, et forment ainsi des tranchées.

Pour cela on réalise un masque 440 au-dessus de la couche cristalline superficielle 410. Le masque forme des bandes parallèles 441 recouvrant la couche cristalline superficielle 410 et laisse à découvert d'autres bandes parallèles de la couche cristalline superficielle 410.

Le masque 440 est réalisé par dépôt ou croissance d'une couche d'oxyde de silicium (SiO2) ou de nitrure de silicium (SiN) **430.** Puis on forme les bandes 441 par lithographie, par exemple par photolithographie classique et gravure de la couche de masquage 430.

Les bandes parallèles **441** sont orientées dans une direction cristalline prédéterminée de la couche cristalline superficielle 410. La couche cristalline 410 présente une face interne en regard de la couche d'arrêt 420 et une face externe opposée à la face interne, ladite face externe étant également désignée surface supérieure. La direction d'orientation des bandes parallèles **441** doit correspondre à une direction commune au plan de la face externe de la couche cristalline 410 et au plan <111> que l'on veut révéler par attaque chimique. Cette direction est une direction de type <110>. Ainsi les bandes 441 sont parallèles à l'intersection entre le plan de la surface supérieure de la couche cristalline 410 et le plan <111 >. Dans l'exemple de mise en œuvre de l'invention illustré par la figure 4, il s'agit d'une direction du type <110>.

La couche cristalline superficielle 410 peut ensuite être gravée chimiquement en utilisant par exemple du KOH déjà mentionné ou encore du tétra-méthyl ammonium hydroxyde ou TMAH.

Les rainures 460 ainsi formées par gravure sont parallèles aux bandes 441. Ainsi ces rainures 460 définissent des rainures parallèles orientées selon la direction commune au plan de la face externe de la couche cristalline 410 et au plan <111 >.

Dans le cadre de l'invention, avantageusement, la gravure s'arrête automatiquement lorsque la couche d'arrêt **420,** faite de SiO2 dans cet exemple non limitatif, est atteinte. Ainsi la gravure s'arrête avant que les facettes 330 d'orientation {111} se rejoignent comme c'est le cas du procédé conventionnel décrit dans l'état de la technique où l'on utilise un substrat de silicium massif.

Ainsi, plutôt que de fixer la hauteur des facettes 330 d'orientation {111} par le temps d'attaque, celle-ci est complètement déterminée, avec le procédé de l'invention, par l'épaisseur de la couche cristalline superficielle 410 de silicium du substrat SOI.

La hauteur de la facette 330, dépendent de la profondeur de la rainure 460. Hauteur de facette 330 et profondeur de la rainure 460 sont mesurées perpendiculairement au plan dans lequel s'étendent principalement les différentes couches 402, 420, 410, c'est-à-dire selon la verticale sur les figures 4a à 4i.

Les rainures 460 présentent donc de préférence un fond 421 plat. Ce fond est formé par la face supérieure de la couche d'arrêt 420.

Comme déjà mentionné plus haut, les bains chimiques sont le lieu d'inhomogénéités. L'utilisation de substrats SOI ou, plus généralement, de substrats SOX, permet ainsi d'obtenir des facettes **330** très homogènes en hauteur sur toute la surface du substrat et d'épaisseur contrôlée en dépit des inhomogénéités dues à la gravure chimique. La non uniformité résiduelle est alors celle de l'épaisseur **411** de la couche de silicium du SOI qui n'est que de quelques pourcents comme spécifié par différents fournisseurs de ce type de substrats. Ceci reste vrai pour des substrats (aussi communément désignés par les termes de plaque ou wafer) de grand diamètre (typiquement 300 mm) et des épaisseurs fines de la couche superficielle de silicium (inférieures à 20 nm).

Selon un mode de réalisation, une fois les rainures 460 réalisées, on forme ensuite un masque 490 configuré pour recouvrir toute la face supérieure de la structure à l'exception des facettes 330 d'orientation {111}. Ce masque 490 est illustré sur la figure 4g. Ce masque 490 est typiquement formé d'un oxyde par exemple de SiO2.

Ainsi cette étape de masquage de la surface supérieure du substrat cristallin est réalisée de telle sorte que les facettes 331 d'orientation {111} opposées aux facettes 330 présentant une orientation cristalline {111} sont masquées.

La réalisation de ce masque 490 comprend typiquement le dépôt d'un matériau comprenant au moins l'un parmi : l'oxyde de silicium (SiO2), le nitrure de silicium (SiN), le nitrure de titane (TiN).

Selon un premier mode de réalisation, le dépôt de ce masque 490 est un dépôt angulaire exécuté de telle sorte que toute la surface supérieure du substrat cristallin 410 soit masquée, à l'exception desdites facettes 330 qui présentent une orientation cristalline {111}. L'angle d'inclinaison du dépôt fait qu'une partie de la tranchée, correspondant aux facettes 330, n'est pas accessible et donc ne reçoit donc pas le matériau déposé. Cette étape est accomplie avec l'aide d'un équipement standard connu sous le nom de pulvérisateur par rayonnement ionique ("ion beam sputter" ou IBS) dans lequel l'angle de dépôt peut être ajusté. Ce dépôt avec un angle incliné peut également être obtenu par la technique dite "Electron beam physical vapor deposition » (EBPVD), signifiant en français dépôt physique en phase gazeuse par faisceau d'électrons, dans laquelle une anode cible sous vide est bombardée par un faisceau d'électrons.

Alternativement à ces techniques permettant un dépôt incliné du matériau formant le masque 490, on peut également prévoir de déposer une couche de masquage d'un matériau comprenant au moins l'un parmi : l'oxyde de silicium (SiO2), le nitrure de silicium (SiN), le nitrure de titane (TiN), puis, suite au dépôt on met à nu les facettes 330 d'orientation {111} afin de les découvrir et permettre le contact entre le nitrure à épitaxier et le silicium des facettes 330 d'orientation {111}.

Comme montré sur la figure 4h, les cristallites **470** que l'on fait croître ensuite à partir de ces facettes 330 d'orientation {111} sont alors tous d'une taille sensiblement égale, à l'incertitude près sur la variation d'épaisseur **411** de la couche cristalline **410,** facilitant grandement la coalescence et l'obtention de surfaces semi-polaires planes **480** sur toute l'étendue d'un substrat comme illustré sur la figure 4i.

Selon un mode de réalisation on faire croitre une première couche de nitrure par épitaxie et directement au contact des facettes 330 d'orientation {111} de la couche cristalline. Typiquement, cette première couche de nitrure est du Aln. Puis on fait ensuite croitre un deuxième nitrure, par exemple du GaN, à partir de la première couche de nitrure épitaxiée. L'interface entre les couches les première et deuxième couche de nitrure n'est pas représentée sur les figures. Cette première couche de nitrure, typiquement en ou à base d'Aln, permet de réduire le phénomène de melt back etching comme expliqué précédemment.

Les dimensions des facettes **330** d'orientation {111} obtenues à partir de la couche cristalline superficielle **410** sont préférentiellement comprises dans une gamme de valeurs allant de 20 nm à 2 $\mu$m qui correspond à une gamme d'épaisseurs **411** de la couche superficielle de l'ordre de 10 nm à 1 $\mu$m selon l'orientation cristalline de la surface de départ. Les périodes de répétition des bandes **441** du masque **440** sont préférentiellement comprises dans une gamme de valeurs allant de 2 à 10 $\mu$m.

Il convient de mentionner que l'utilisation de facettes **330** de très petites tailles que l'on peut obtenir avec le procédé de l'invention, même sur des substrats de grande dimension, permet de grandement minimiser voire d'éliminer le problème du « melt-back etching » décrit dans l'état de la technique et qui apparaît lors de l'étape de croissance de la couche de GaN. Comme on l'a vu, ce phénomène destructif s'explique par la réactivité du silicium qui est porté à des températures assez élevées lors de la phase de croissance des cristallites pour qu'il puisse réagir avec le gallium. Ce qui entraine généralement le creusement de cavités du fait d'une gravure intempestive du silicium du substrat réagissant avec le gallium. La couche tampon d'AIN (non représentée) que l'on dépose sur le silicium avant de commencer la croissance de GaN, s'avère pouvoir être ici beaucoup plus efficace en raison des faibles surfaces de silicium exposées lors de la croissance, réduisant drastiquement voire éliminant complètement ce problème.

On notera finalement que la structure SOX utilisée va permettre de pratiquer un décollement aisé de la couche **480** de nitrure d'orientation semi-polaire que l'on a fait croître à partir des facettes **330.** En effet les interfaces entre la couche cristalline 330 et la couche d'arrêt 420 (par exemple une interface Si/SiO2) sont mécaniquement fragiles ce qui va permettre de séparer sans casse les couches de nitrure **480** de leur substrat d'origine, pour peu qu'elles soient d'épaisseur suffisante, obtenant ainsi des couches homogènes de GaN indépendantes dites aussi « free-standing ». Pour des épaisseurs de couche de plusieurs centaines de micromètres ($\mu$m) on obtient alors des « pseudo-substrats » semi-polaires qui peuvent être de très grande taille notamment si on les compare à ceux obtenus, comme décrit dans l'état de la technique, par découpage en biais d'un lingot de GaN d'orientation c, d'un diamètre qui ne dépasse pas 1 pouce ou 2,5 cm, taille maximale que l'on sait obtenir actuellement.

Selon un mode de réalisation non illustré, on procède à une étape additionnelle après l'étape d'obtention de la pluralité de rainures parallèles et avant l'étape de croissance épitaxiale de la couche cristalline. Cette étape additionnelle comprend la réalisation d'une pluralité de tranchées parallèles qui s'étendent dans une direction ayant subi une rotation par rapport à direction principale selon laquelle les rainures 360 parallèles s'étendent.

Selon un mode de réalisation, les tranchées sont tournées, par rapport aux rainures 360, d'un angle qui est supérieur à 40° et qui est de préférence compris entre 50° et 90°, cet angle est mesuré dans un plan parallèle au plan principal dans lequel s'étend la couche support 402.

Ainsi, les tranchées interrompent ainsi les rainures 360 continues de manière à former une matrice de facettes individuelles présentant chacune une orientation cristalline {111}. Ainsi pendant l'étape de croissance épitaxiale, le matériau croît uniquement à partir desdites facettes individuelles qui présentent une orientation cristalline {111} et qui forment ladite matrice. De préférence, les tranchées et les rainures présentent chacune un fond, le fond des tranchées se trouvant à la même profondeur ou en dessous du fond des rainures.

La formation des tranchées, inclinées par rapport aux rainures, permet de réduire les superficies disponibles des facettes présentant une orientation cristalline {111}. Ce mode de réalisation optionnel mais avantageux permet ainsi une réduction de l'empreinte servant à la croissance épitaxiale et ainsi une réduction des défauts pendant la croissance épitaxiale générée à l'interface GaN/AIN/Si ou AIN/Si tout en imposant la croissance dans la direction +c adéquate.

L'invention n'est pas limitée aux modes de réalisation décrits ci-dessus et s'étend à tous les modes de réalisation couverts par les revendications.

**Revendications**

**1.** Procédé permettant d'obtenir au moins une couche semi-polaire (480) de nitrure, N, obtenue à partir d'au moins l'un parmi le gallium, Ga, l'indium, In, et l'aluminium, AI, sur une surface supérieure d'une couche cristalline (410) à base de silicium ou à base de germanium, ledit procédé comprenant les étapes suivantes:

- graver à partir de la surface supérieure de la couche cristalline, une pluralité de rainures parallèles (460) qui s'étendent principalement dans une première direction, chaque rainure (460) comprenant au moins deux facettes inclinées opposées (330, 331), au moins l'une (330) desdites deux facettes opposées (330, 331) présentant une orientation cristalline {111} ;
- former un masque (490) au-dessus de la surface supérieure de la couche cristalline (410) de telle sorte que les facettes (331) opposées auxdites facettes (330) présentant une orientation cristalline {111} soient masquées et que lesdites facettes (330) présentant une orientation cristalline {111} ne soient pas masquées ;
- croissance épitaxiale de ladite couche semi-polaire (480) de nitrure à partir desdites facettes (330) non masquées;

adite gravure étant effectuée à partir d'un empilement comprenant la couche cristalline (410) et au moins une couche d'arrêt (420) surmontée par la couche cristalline (410), ladite gravure gravant ladite couche cristalline (410) de manière sélective par rapport à ladite couche d'arrêt (420) de manière à ce que ladite gravure s'arrête au contact de ladite couche d'arrêt (420), et **caractérisé en ce que** la couche cristalline (410) présente une épaisseur inférieure ou égale à 900 nm.

2. Procédé selon la revendication précédente, dans lequel l'épaisseur de la couche cristalline (410) est telle que lors de l'étape de gravure les deux facettes inclinées opposées (330, 331) d'une même rainure (460) parviennent à la couche d'arrêt (420) sans se rejoindre.

3. Procédé selon l'une quelconque des revendications précédentes, dans lequel ladite première direction, selon lesquelles les rainures (460) s'étendent, correspond à une direction commune au plan de ladite surface supérieure et au plan <111>.

4. Procédé selon l'une quelconque des revendications précédentes, dans lequel ladite étape de croissance épitaxiale comprend :

- une première croissance épitaxiale d'un matériau à base de nitrure d'aluminium**,** AlN, à partir desdites facettes (330) non masquées qui présentent une orientation cristalline {111} ;
- puis au moins une seconde croissance épitaxiale d'un matériau à base de nitrure de gallium, GaN, (480) à partir dudit matériau à base de nitrure d'aluminium, AlN.

5. Procédé selon l'une quelconque des revendications précédentes, dans lequel la couche d'arrêt (420) est configurée pour permettre une croissance épitaxiale à partir de la couche cristalline (410) sans croissance épitaxiale à partir de la couche d'arrêt (420).

6. Procédé selon l'une quelconque des revendications précédentes, dans lequel la couche cristalline (410) est au contact direct de la couche d'arrêt (420).

7. Procédé selon l'une quelconque des revendications précédentes, dans lequel l'empilement comprend une couche support (402) surmontée par la couche d'arrêt (420).

8. Procédé selon la revendication précédente, dans lequel la couche d'arrêt (420) est au contact direct de la couche support (402).

9. Procédé selon l'une quelconque des deux revendications précédentes, dans lequel la couche d'arrêt (420) est obtenue par oxydation d'une surface au moins de la couche support (402).

10. Procédé selon l'une quelconque des revendications précédentes, dans lequel la couche d'arrêt (420) est une couche prise parmi : une couche d'oxyde, une couche de SiC, une couche de $Al_2O_3$.

11. Procédé selon l'une quelconque des revendications précédentes, dans lequel la couche cristalline (410) présente une épaisseur comprise entre 2 nm et 900nm et de préférence entre 5nm et 500 nm et de préférence entre 10 nm et 50nm.

12. Procédé selon l'une quelconque des revendications 1 à 10, dans lequel la couche cristalline (410) présente une épaisseur inférieure ou égale à 750 nm.

13. Procédé selon la revendication précédente, dans lequel la couche cristalline (410) présente une épaisseur inférieure ou égale à 600 nm et de préférence inférieure ou égale à 500 nm et de préférence inférieure ou égale à 300 nm et de préférence inférieure ou égale à 200 nm.

14. Procédé selon l'une quelconque des revendications 1 à 10, dans lequel la couche cristalline (410) présente une épaisseur comprise entre 50 nm et 600nm et de préférence une épaisseur comprise entre 50 nm et 300nm.

15. Procédé selon l'une quelconque des revendications précédentes, dans lequel la couche cristalline (410) est une couche préalablement obtenue sur un substrat donneur puis reporté sur la couche d'arrêt (420).

16. Procédé selon l'une quelconque des revendications précédentes, dans lequel l'étape de formation d'un masque (490) comprend un dépôt angulaire d'un matériau de masquage, exécuté de telle sorte que toute la couche cristalline (410) soit recouverte à l'exception desdites facettes (330) qui présentent une orientation cristalline {111}.

17. Procédé selon la revendication précédente, dans lequel le matériau de masquage comprend au moins l'un parmi les matériaux suivants: l'oxyde de silicium, $SiO_2$, le nitrure de silicium, SiN, le nitrure de titane, TiN.

18. Procédé selon l'une quelconque des revendications précédentes, dans lequel le nitrure est du nitrure de gallium, GaN.

19. Procédé selon l'une quelconque des revendications précédentes, dans lequel la pluralité de rainures parallèles (460) présente un pas p1 qui est compris entre 50 nm et 20 $\mu$m.

20. Procédé selon l'une quelconque des revendications précédentes, dans lequel les rainures (460) parallèles de la pluralité de rainures parallèles (460) s'étendent principalement dans une première direction,
le procédé comprend également les étapes suivantes exécutées après l'étape d'obtention de la pluralité de rainures parallèles (460) et avant l'étape de croissance épitaxiale de la couche cristalline (480):

- graver une pluralité de tranchées parallèles qui s'étendent dans une seconde direction ayant subi une rotation par rapport à ladite première direction, en interrompant ainsi les rainures continues (460) de manière à former une matrice (335) de facettes individuelles (330') présentant chacune une orientation cristalline {111} ; les tranchées et les rainures (460) présentant chacune un fond, le fond des tranchées se trouvant à la même profondeur ou en dessous du fond (421) des rainures (460);

et dans lequel, pendant ladite étape de croissance épitaxiale, ledit matériau (480) croît uniquement à partir desdites facettes individuelles (330') qui présentent une orientation cristalline {111} et qui forment ladite matrice (335).

21. Procédé selon la revendication précédente, dans lequel lesdites première et seconde directions définissent un angle (470) qui est supérieur à 40° et qui est de préférence compris entre 50° et 90°.

22. Procédé selon l'une quelconque des deux revendications précédentes, dans lequel la pluralité de rainures parallèles (460) présente un pas p1 et dans lequel la pluralité de tranchées parallèles présentent un pas p2 qui est supérieur à $\frac{p1*0.8}{2.5}$ et de préférence supérieur à $\frac{p1*0.9}{2.5}$.

23. Procédé selon l'une quelconque des trois revendications précédentes, dans lequel la pluralité de rainures parallèles (460) présente un pas p1 et dans lequel la pluralité de tranchées parallèles présente un pas p2 qui est inférieur à 1,1*p1 et de préférence inférieur à p1.

24. Dispositif microélectronique comprenant une couche cristalline (410) et une couche semi-polaire (480) d'au moins une couche de nitrure d'au moins l'un parmi le gallium, Ga, l'indium, In, et l'aluminium, Al, sur une surface supérieure de la couche cristalline (410),

- la couche cristalline (410) comprenant une pluralité de rainures parallèles (460), chaque rainure (460) comprenant au moins deux facettes inclinées opposées (330, 331) formant chacune une bande continue, au moins l'une desdites deux facettes opposées (330) présentant une orientation cristalline {111} ;
- ladite couche de nitrure étant en contact direct avec les facettes (330) présentant une orientation cristalline {111} ;
la couche cristalline (410) surmontant une couche d'arrêt (420), chaque rainure (460) s'étendant depuis une face supérieure de la couche d'arrêt (420) et traversant toute la couche cristalline (410),
le dispositif étant **caractérisé en ce que** la couche cristalline (410) présente une épaisseur inférieure ou égale à 900 nm.

25. Dispositif selon la revendication précédente, dans lequel les rainures (460) présentent un fond (421) plat formé par la face supérieure de la couche d'arrêt (420).

26. Diodes électroluminescentes, LED, comprenant un dispositif microélectronique selon l'une quelconque des deux revendications précédentes.

**Patentansprüche**

1. Verfahren zum Erhalten von mindestens einer semipolaren Schicht (480) aus Nitrid, N, das aus mindestens einem der Elemente Gallium, Ga, Indium, In, und Aluminium, Al, erhalten wird, auf einer oberen Oberfläche einer kristallinen Schicht (410) auf Silizium- oder Germaniumbasis, wobei das Verfahren die folgenden Schritte umfasst:

   - Ätzen einer Vielzahl paralleler Rillen (460) ausgehend von der oberen Oberfläche der kristallinen Schicht, die sich hauptsächlich in einer ersten Richtung erstrecken, wobei jede Rille (460) mindestens zwei einander gegenüberliegende geneigte Facetten (330, 331) umfasst, wobei mindestens eine (330) der beiden einander gegenüberliegenden Facetten (330, 331) eine kristalline Orientierung {111} aufweist;
   - Bilden einer Maske (490) über der oberen Oberfläche der kristallinen Schicht (410), sodass die Facetten (331), die den Facetten (330) mit einer kristallinen Orientierung {111} gegenüberliegen, maskiert werden und die Facetten (330) mit einer kristallinen Orientierung {111} nicht maskiert werden;
   - epitaktisches Aufwachsen der semipolaren Schicht (480) aus Nitrid, ausgehend von den unmaskierten Facetten (330);

   wobei das Ätzen ausgehend von einem Stapel durchgeführt wird, der die kristalline Schicht (410) und mindestens eine Stoppschicht (420) umfasst, auf der sich die kristalline Schicht (410) befindet, wobei das Ätzen die kristalline Schicht (410) selektiv bezogen auf die Stoppschicht (420) ätzt, sodass das Ätzen in Kontakt mit der Stoppschicht (420) zum Stillstand kommt, **dadurch gekennzeichnet, dass** die kristalline Schicht (410) eine Dicke von kleiner oder gleich 900 nm aufweist.

2. Verfahren nach dem vorstehenden Anspruch, wobei die Dicke der kristallinen Schicht (410) so bemessen ist, dass während des Ätzschritts die beiden einander gegenüberliegenden geneigten Facetten (330, 331) derselben Nut (460) die Stoppschicht (420) erreichen, ohne sich zu verbinden.

3. Verfahren nach einem der vorstehenden Ansprüche, wobei die erste Richtung, in der sich die Rillen (460) erstrecken, einer Richtung entspricht, die der Ebene der oberen Oberfläche und der Ebene <111> gemeinsam ist.

4. Verfahren nach einem der vorstehenden Ansprüche, wobei der Schritt des epitaktischen Aufwachsens umfasst:

   - ein erstes epitaktisches Aufwachsen eines auf Aluminiumnitrid, AIN, basierenden Materials, ausgehend von den unmaskierten Facetten (330), die eine kristalline Orientierung {111} aufweisen,
   - dann mindestens ein zweites epitaktisches Aufwachsen eines auf Galliumnitrid, GaN, basierenden Materials (480), ausgehend von dem auf Aluminiumnitrid, AIN, basierenden Material.

5. Verfahren nach einem der vorstehenden Ansprüche, wobei die Stoppschicht (420) so ausgelegt ist, dass sie ein epitaktisches Aufwachsen, ausgehend von der kristallinen Schicht (410) ohne epitaktisches Aufwachsen, ausgehend von der Stoppschicht (420) ermöglicht.

6. Verfahren nach einem der vorstehenden Ansprüche, wobei die kristalline Schicht (410) in direktem Kontakt mit der Stoppschicht (420) steht.

7. Verfahren nach einem der vorstehenden Ansprüche, wobei der Stapel eine Trägerschicht (402) umfasst, die von der Stoppschicht (420) überlagert wird.

8. Verfahren nach dem vorstehenden Anspruch, wobei die Stoppschicht (420) in direktem Kontakt mit der Trägerschicht (402) steht.

9. Verfahren nach einem der beiden vorstehenden Ansprüche, wobei die Stoppschicht (420) durch Oxidation mindestens einer Oberfläche der Trägerschicht (402) erhalten wird.

10. Verfahren nach einem der vorstehenden Ansprüche, wobei die Stoppschicht (420) eine Schicht ist, die ausgewählt ist aus: einer Oxidschicht, einer SiC-Schicht oder einer $Al_2O_3$-Schicht.

11. Verfahren nach einem der vorstehenden Ansprüche, wobei die kristalline Schicht (410) eine Dicke zwischen 2 nm und 900 nm und vorzugsweise zwischen 5 nm und 500 nm und vorzugsweise zwischen 10 nm und 50 nm aufweist.

12. Verfahren nach einem der Ansprüche 1 bis 10, wobei die kristalline Schicht (410) eine Dicke von weniger als oder gleich 750 nm aufweist.

13. Verfahren nach dem vorstehenden Anspruch, wobei die kristalline Schicht (410) eine Dicke kleiner oder gleich 600 nm und vorzugsweise kleiner oder gleich 500 nm und vorzugsweise kleiner oder gleich 300 nm und vorzugsweise kleiner oder gleich 200 nm aufweist.

14. Verfahren nach einem der Ansprüche 1 bis 10, wobei die kristalline Schicht (410) eine Dicke zwischen 50 nm und 600 nm und vorzugsweise eine Dicke zwischen 50 nm und 300 nm aufweist.

15. Verfahren nach einem der vorstehenden Ansprüche, wobei die kristalline Schicht (410) eine Schicht ist, die zuvor auf einem Donorsubstrat erhalten und dann auf die Stoppschicht (420) übertragen wurde.

16. Verfahren nach einem der vorstehenden Ansprüche, wobei der Schritt des Bildens einer Maske (490) das Aufbringen eines Maskenmaterials unter einem Winkel umfasst, das so durchgeführt wird, dass die gesamte kristalline Schicht (410) mit Ausnahme der Facetten (330), die eine kristalline Orientierung {111} aufweisen, bedeckt ist.

17. Verfahren nach dem vorstehenden Anspruch, wobei das Maskierungsmaterial mindestens eines der folgenden Materialien umfasst: Siliziumoxid, $SiO_2$, Siliziumnitrid, SiN, Titannitrid, TiN.

18. Verfahren nach einem der vorstehenden Ansprüche, wobei das Nitrid Galliumnitrid, GaN ist.

19. Verfahren nach einem der vorstehenden Ansprüche, wobei die Vielzahl paralleler Rillen (460) einen Abstand p1 zwischen 50 nm und 20 $\mu$m aufweist.

20. Verfahren nach einem der vorstehenden Ansprüche, wobei die parallelen Rillen (460) der Vielzahl paralleler Rillen (460) hauptsächlich in einer ersten Richtung verlaufen, wobei das Verfahren außerdem die folgenden Schritte umfasst, die nach dem Schritt des Erhaltens der Vielzahl paralleler Rillen (460) und vor dem Schritt des epitaktischen Aufwachsens der kristallinen Schicht (480) ausgeführt werden:

    - Ätzen einer Vielzahl paralleler Gräben, die sich in eine zweite Richtung erstrecken, die relativ zur ersten Richtung gedreht ist, wodurch die durchgehenden Rillen (460) unterbrochen werden, um eine Matrix (335) aus einzelnen Facetten (330') zu bilden, die jeweils eine kristalline Orientierung {111} aufweisen; wobei die Gräben und Rillen (460) jeweils einen Boden aufweisen, wobei der Boden der Gräben sich auf der gleichen Tiefe wie der Boden (421) der Rillen (460) oder unterhalb davon befindet; und wobei das Material (480) während des Schrittes des epitaktischen Aufwachsens nur ausgehend von den einzelnen Facetten (330') wächst, die eine kristalline Orientierung {111} aufweisen und die Matrix (335) bilden.

21. Verfahren nach dem vorstehenden Anspruch, wobei die erste und die zweite Richtung einen Winkel (470) definieren, der größer als 40° ist und vorzugsweise zwischen 50° und 90° liegt.

22. Verfahren nach einem der beiden vorstehenden Ansprüche, wobei die Vielzahl paralleler Rillen (460) einen Abstand p1 aufweist und wobei die Vielzahl paralleler Gräben einen Abstand p2 aufweist, der größer ist als $\frac{p1*0,8}{2,5}$ und vorzugsweise größer ist als $\frac{p1*0,9}{2,5}$ .

**23.** Verfahren nach einem der drei vorstehenden Ansprüche, wobei die Vielzahl paralleler Rillen (460) einen Abstand p1 aufweist und wobei die Vielzahl paralleler Gräben einen Abstand p2 aufweist, der kleiner als 1,1 * p1 und vorzugsweise kleiner als p1 ist.

**24.** Mikroelektronische Vorrichtung, umfassend eine kristalline Schicht (410) und eine semipolare Schicht (480) aus mindestens einer Nitridschicht aus mindestens einem der Elemente Gallium, Ga, Indium, In, und Aluminium, Al, auf einer oberen Oberfläche der kristallinen Schicht (410),

    - wobei die kristalline Schicht (410) eine Vielzahl paralleler Rillen (460) umfasst, wobei jede Rille (460) mindestens zwei einander gegenüberliegende geneigte Facetten (330, 331) umfasst, die jeweils ein kontinuierliches Band bilden, wobei mindestens eine der beiden einander gegenüberliegenden Facetten (330) eine kristalline Orientierung {111} aufweist;
    - wobei die Nitridschicht in direktem Kontakt mit den Facetten (330) steht, die eine kristalline Orientierung {111} aufweisen;

wobei die kristalline Schicht (410) einer Stoppschicht (420) überlagert ist, wobei sich jede Rille (460) von einer Oberseite der Stoppschicht (420) erstreckt und die gesamte kristalline Schicht (410) durchquert, wobei die Vorrichtung **dadurch gekennzeichnet ist, dass** die kristalline Schicht (410) eine Dicke von kleiner oder gleich 900 nm aufweist.

**25.** Vorrichtung nach dem vorstehenden Anspruch, bei der die Nuten (460) einen flachen Boden (421) aufweisen, der durch die Oberseite der Stoppschicht (420) gebildet wird.

**26.** Leuchtdioden, LEDs, umfassend eine mikroelektronische Vorrichtung nach einem der beiden vorstehenden Ansprüche.

## Claims

**1.** A process allowing at least one semipolar layer (480) of nitride N to be obtained, which layer is obtained from a least one among gallium, Ga, indium, In, and aluminum, Al, on a top surface of a single-crystal layer (410) based on silicon or based on germanium, said process comprising the following steps:

    - etching, from the top surface of the single-crystal layer, a plurality of parallel grooves (460) that mainly extend in a first direction, each groove (460) comprising at least two opposite inclined facets (330, 331), at least one (330) of said two opposite facets (330, 331) having a {111} crystal orientation;
    - forming a mask (490) on top of the top surface of the single-crystal layer (410) such that the facets (331) opposite said facets (330) having a {111} crystal orientation are masked and that said facets (330) having a {111} crystal orientation are not masked; and
    - epitaxial growth of said semipolar layer (480) of nitride from said not masked facets (330);
said etching being carried out on a stack comprising the single-crystal layer (410) and at least one stop layer (420) that is surmounted by the single-crystal layer (410),
said etching engraving said single-crystal layer (410) selectively with respect to said stop layer (420) so that said etching stops on contact with said stop layer (420), **characterized in that** the single-crystal layer (410) has a thickness smaller than or equal to 900 nm .

**2.** The process as claimed in the preceding claim, wherein the thickness of the single-crystal layer (410) is such that, in the etching step, the two opposite inclined facets (330, 331) of a given groove (460) reach the stop layer (420) without meeting.

**3.** The process as claimed in any one of the preceding claims, wherein said first direction, in which the grooves (460) extend, corresponds to a direction common to the plane of said top surface and to the <111> plane.

**4.** The process as claimed in any one of the preceding claims, wherein said step of epitaxial growth comprises:

    - a first epitaxial growth of a material based on aluminum nitride ,AlN, from said not masked facets (330) that have a {111} crystal orientation;
    - then at least one second epitaxial growth of a material based on gallium nitride ,GaN, (480) from said material based on aluminum nitride, AlN.

5. The process as claimed in any one of the preceding claims, wherein the stop layer (420) is configured to allow an epitaxial growth from the single-crystal layer (410) without epitaxial growth from the stop layer (420).

6. The process as claimed in any one of the preceding claims, wherein the single-crystal layer (310) makes direct contact with the stop layer (420).

7. The process as claimed in any one of the preceding claims, wherein the stack comprises a carrier layer (402) surmounted by the stop layer (420).

8. The process as claimed in the preceding claim, wherein the stop layer (420) makes direct contact with the carrier layer (402).

9. The process as claimed in any one of the two preceding claims, wherein the stop layer (420) is obtained by oxidizing one surface at least of the carrier layer (402).

10. The process as claimed in any one of the preceding claims, wherein the stop layer (420) is a layer chosen from: a layer of oxide, a layer of SiC, and a layer of $Al_2O_3$.

11. The process as claimed in any one of the preceding claims, wherein the single-crystal layer (410) has a thickness comprised between 2 nm and 900 nm and preferably between 5 nm and 500 nm and preferably between 10 nm and 50 nm.

12. The process as claimed in any one of claims 1 to 10, wherein the single-crystal layer (410) has a thickness smaller than or equal to 750 nm.

13. The process as claimed in the preceding claim, wherein the single-crystal layer (410) has a thickness smaller than or equal to 600 nm and preferably smaller than or equal to 500 nm and preferably smaller than or equal to 300 nm and preferably smaller than or equal to 200 nm.

14. The process as claimed in any one of claims 1 to 10, wherein the single-crystal layer (410) has a thickness comprised between 50 nm and 600 nm and preferably a thickness comprised between 50 nm and 300 nm.

15. The process as claimed in any one of the preceding claims, wherein the single-crystal layer (410) is a layer obtained beforehand on a donor substrate then added to the stop layer (420).

16. The process as claimed in any one of the preceding claims, wherein the step of forming a mask (490) comprises an angular deposition of a masking material, which deposition is carried out such that all the single-crystal layer (410) is covered with the exception of said facets (330) that have a {111} crystal orientation.

17. The process as claimed in the preceding claim, wherein the masking material comprises at least one among the following materials: silicon oxide, $SiO_2$, silicon nitride ,SiN, and titanium nitride, TiN.

18. The process as claimed in any one of the preceding claims, wherein the nitride is gallium nitride ,GaN.

19. The process as claimed in any one of the preceding claims, wherein the plurality of parallel grooves (460) has a pitch p1 that is comprised between 50 nm and 20 $\mu$m.

20. The process as claimed in any one of the preceding claims, wherein the parallel grooves (460) of the plurality of parallel grooves (460) mainly extend in a first direction, and
the process also comprises the following steps, which are executed after the step of obtaining the plurality of parallel grooves (460) and before the step of epitaxial growth of the single-crystal layer (480):

- etching a plurality of parallel trenches that extend in a second direction having undergone a rotation with respect to said first direction, and that thus interrupt the continuous grooves (460) so as to form a matrix-array (335) of individual facets (330') each having a {111} single-crystal orientation; the trenches and the grooves (460) each having a bottom, the bottom of the trenches being located at the same depth or below the bottom (421) of the grooves (460);

and wherein, during said epitaxial growth step, said material (480) grows solely from said individual facets (330') that have a {111} crystal orientation and that form said matrix-array (335).

21. The process as claimed in the preceding claim, wherein said first and second directions define an angle (470) that is larger than 40° and that is preferably comprised between 50° and 90°.

22. The process as claimed in any one of the two preceding claims, wherein the plurality of parallel grooves (460) has a pitch p1 and wherein the plurality of parallel trenches have a pitch p2 that is larger than $\frac{p1*0.8}{2.5}$ and preferably larger than $\frac{p1*0.9}{2.5}$ .

23. The process as claimed in any one of the three preceding claims, wherein the plurality of parallel grooves (460) has a pitch p1 and wherein the plurality of parallel trenches has a pitch p2 that is smaller than 1.1 *p1 and preferably lower than p1.

24. A microelectronic device comprising a single-crystal layer (410) and a semipolar layer (480) of at least one layer of a nitride of at least one among gallium, Ga, indium, In and aluminum, Al, on a top surface of the single-crystal layer (410),

- the single-crystal layer (410) comprising a plurality of parallel grooves (460), each groove (460) comprising at least two opposite inclined facets (330, 331) each forming a continuous band, at least one of said two opposite facets (330) having a {111} crystal orientation;
- said nitride layer making direct contact with the facets (330) having a {111} crystal orientation;
the single-crystal layer (410) surmounting a stop layer (420), each groove (460) extending from a top face of the stop layer (420) and passing right through the single-crystal layer (410),
the device being **characterized in that** the single-crystal layer (410) has a thickness smaller than or equal to 900 nm.

25. The device as claimed in the preceding claim, wherein the grooves (460) have a flat bottom (421) that is formed by the top face of the stop layer (420).

26. A light-emitting diodes, LED, comprising a micro-electronic device as claimed in either one of the two preceding claims.

FIG. 1

FIG. 2

FIG. 3a

FIG. 3b

FIG. 3c

FIG. 3d

340 —
330 —
331

**FIG. 3e**

**FIG. 3f**

402

**FIG. 4a**

420
402

**FIG. 4b**

400 {

410
420
402

**FIG. 4c**

430
410
420
402

**FIG. 4d**

441

440

441

441

410

420

402

**FIG. 4e**

441

330    460

411

421

330    460

441

330    460

441

410

420

402

421

421

421    460    421    460

330    331    330    331

441

410

420

402

**FIG. 4f**

**FIG. 4g**

470

470

490

441

410

420

402

480

490

441

410

420

402

330   421   331   330   421   331

**FIG. 4h**

480

490

441

410

420

402

**FIG. 4i**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012119218 A1

**Littérature non-brevet citée dans la description**

- Defect reduction methods for III-nitride heteroepitaxial films grown along nonpolar and semipolar orientations. *Semiconductor Science and Technology*, 2012, vol. 27 (2)
- **T. HONDA**. *Journal of Crystal Growth*, 2002, vol. 242 (1-2), 82
- **B. LEUNG et al.** *Applied Physics Letters*, 2014, vol. 104 (26)
- **T. TANIKAWA et al.** *physica status solidi (c)*, 2008, vol. 5 (9), 2966